# EUROPEAN PATENT APPLICATION

(11) **EP 4 447 310 A1**
(43) Date of publication of application: **16.10.2024**
(21) Application number: 24169785.3
(22) Date of filing: 11.04.2024
(51) Int. Cl.: H02P 27/08, H02H 7/08

(54) **SAFETY CIRCUIT FOR A GATE DRIVER DEVICE, CORRESPONDING GATE DRIVER DEVICE AND DRIVER SYSTEM**

(30) Priority: 14.04.2023 IT 202300007197
(71) Applicant: STMicroelectronics International N.V., 1228 Plan-les-Ouates, Geneva (CH)
(72) Inventor: POLI, Enrico, I-24046 Osio Sotto (Bergamo) (IT); MARANO, Vincenzo, I-20092 Cinisello Balsamo (Milano) (IT); FEHER, Andrija, D-70771 Echterdingen (DE); ALASAARI, Pekka Sakari, 33180 Tampere (FI)
(74) Representative: Buzzi, Notaro & Antonielli d'Oulx S.p.A.

(57) **Abstract**

A safety circuit (13) for a gate driver device (14) receives PWM driving signals (INH, INL), a system supply voltage (VDD), as well as first (STO1_INT) and second (STO2_INT) safety signals. The circuit (13) includes a first logic circuit (202, 213) configured to propagate the PWM driving signals (INH, INL) to produce gate driving signals (INHg, INLg) if the first safety signal (STO1_INT) is de-asserted, and disable propagation of the PWM driving signals (INH, INL) and de-assert the gate driving signals (INHg, INLg) if the first safety signal (STO1_INT) is asserted. The circuit (13) includes a second logic circuit (216) configured to couple a power supply output node (502) to the system supply voltage (VDD) to produce a driver supply voltage (VSUPPLY) if the second safety signal (STO2_INT) is de-asserted, and decouple the power supply output node (502) from the system supply voltage (VDD) if the second safety signal (STO2_INT) is asserted.

## Description

### Technical field

The description relates to safety circuits that may be used with (e.g., coupled to or integrated in) gate driver devices (e.g., gate driver integrated circuits, gate driver ICs), in particular for motor control applications.

Such gate driver devices may be applied, for instance, in industrial drivers.

### Technological background

Modern industrial devices, in particular motor drivers, are designed to satisfy several safety requirements. A safety function desirable in the applications that involve motor driving (motor control) is the so-called Safe Torque Off (STO), i.e., a safety function that turns off power at the driver output to prevent the motor from producing torque, thereby fitting specific safety requirements (e.g., as defined by standard EN 61800-5-2, "Adjustable speed electrical power drive systems Part 5-2: Safety requirements").

Conventionally, manufacturers of motor drivers design and certificate their products/solutions based on discrete components and a safety firmware. By doing so, any subsequent change effected on a certified product/solution requires a new certification process, which results in increased certification cost and time, limited integration possibilities (due to the discrete component approach), slow innovation (due to the cost-driven resistance to changes), and even the risk of losing a previously acquired certification.

Therefore, there is a need in the art to provide safety circuits that implement (e.g., incorporate, integrate) the STO safety function within an integrated circuit. Such a safety circuit may then be further integrated into a more complex device such as, for example, a gate driver IC, or may be coupled thereto in the final application.

### Object and summary

An object of one or more embodiments is to contribute in providing such safety circuits that implement a safety STO function in an integrated circuit.

According to one or more embodiments, such an object can be achieved by a safety circuit having the features set forth in the claims that follow.

One or more embodiments may relate to a corresponding gate driver device.

One or more embodiments may relate to a corresponding driver system.

The claims are an integral part of the technical teaching provided herein in respect of the embodiments.

According to an aspect of the present description, an STO safety circuit (e.g., integrated circuit) includes at least one PWM input pin configured to receive at least one PWM driving signal, a power supply input pin configured to receive a system supply voltage, as well as a first safety input pin configured to receive a first safety signal and a second safety input pin configured to receive a second safety signal. The safety circuit includes a high-side driving output node configured to produce a high-side gate driving signal, a low-side driving output node configured to produce a low-side gate driving signal, and a power supply output node configured to produce a driver supply voltage. The safety circuit includes a first logic circuit configured to propagate the at least one PWM driving signal to produce the high-side gate driving signal and the low-side gate driving signal as a function thereof, in response to the first safety signal being de-asserted, and disable propagation of the at least one PWM driving signal and de-assert the high-side gate driving signal and the low-side gate driving signal (e.g., resulting in the high-side switch and the low-side switch of an external power stage being turned off) in response to the first safety signal being asserted. The safety circuit includes a second logic circuit configured to couple the power supply output node to the power supply input pin to propagate the system supply voltage as the driver supply voltage, in response to the second safety signal being de-asserted, and decouple the power supply output node from the power supply input pin to disable propagation of the system supply voltage, in response to the second safety signal being asserted.

One or more embodiments may thus provide a safety circuit that incorporates, at the semiconductor level, a safety STO function and is certified for STO. This facilitates reusing the safety IC in different motor driver products/solutions (either as a stand-alone IC device or integrated into another IC device providing other functions, such as a gate driver or a fully integrated inverter), thereby simplifying the certification flow and reducing the risk of unexpected certification issues.

According to another aspect of the present description, a gate driver device includes a safety circuit according to one or more embodiments of the present description, a level shifter circuit, an output high-side driver circuit, a pre-driver circuit, and an output low-side driver circuit. The level shifter circuit is configured to receive the high-side gate driving signal and drive the output high-side driver circuit as a function thereof. The pre-driver circuit is configured to receive the low-side gate driving signal and drive the output low-side driver circuit as a function thereof. The level shifter circuit and/or the pre-driver circuit and/or the output low-side driver circuit are coupled to the power supply output node of the safety circuit to be biased by the driver supply voltage.

According to another aspect of the present description, a driver system includes a control unit, a safety circuit according to one or more embodiments of the present description coupled to a gate driver device or a gate driver device according to one or more embodiments of the present description, and a power stage. The control unit is configured to produce the at least one PWM driving signal for controlling operation of the power stage. The safety circuit is configured to receive the at least one PWM driving signal, the first safety signal and the second safety signal and produce the high-side gate driving signal, the low-side gate driving signal and the driver supply voltage. The gate driver device is configured to receive the high-side gate driving signal, the low-side gate driving signal and the driver supply voltage and produce shifted PWM driving signals for driving respective switches of the power stage.

### Brief description of the drawings

One or more embodiments will now be described, by way of example only, with reference to the annexed figures, wherein:
- Figures 1 and 2 are circuit block diagrams exemplary of driver systems according to embodiments of the present description;
- Figures 3 and 4 are circuit block diagrams exemplary of safety circuits according to embodiments of the present description for use with a gate driver device, e.g., for use in the driver systems of Figures 1 and 2, respectively;
- Figure 5 is a circuit block diagram exemplary of a first channel of an STO safety circuit according to one or more embodiments of the present description;
- Figure 6 is a circuit block diagram exemplary of a backup activation circuit configured to activate a second channel of an STO safety circuit according to one or more embodiments of the present description;
- Figure 7 is a circuit block diagram exemplary of a second channel of an STO safety circuit according to one or more embodiments of the present description; and
- Figure 8 is a circuit block diagram exemplary of a backup activation circuit configured to activate a first channel of an STO safety circuit according to one or more embodiments of the present description.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is included in at least one embodiment. Hence, phrases such as "in an embodiment" or "in one embodiment" that may be present in one or more points of the present description do not necessarily refer to one and the same embodiment. Moreover, particular configurations, structures, or characteristics may be combined in any adequate way in one or more embodiments.

The headings/references used herein are provided merely for convenience and hence do not define the extent of protection or the scope of the embodiments.

Throughout the figures annexed herein, unless the context indicates otherwise, like parts or elements are indicated with like references/numerals and a corresponding description will not be repeated for the sake of brevity.

As anticipated, one or more embodiments relate to a safety circuit that implements an STO safety function for a gate driver device. The gate driver device may be used in an industrial driver (e.g., a motor driver).

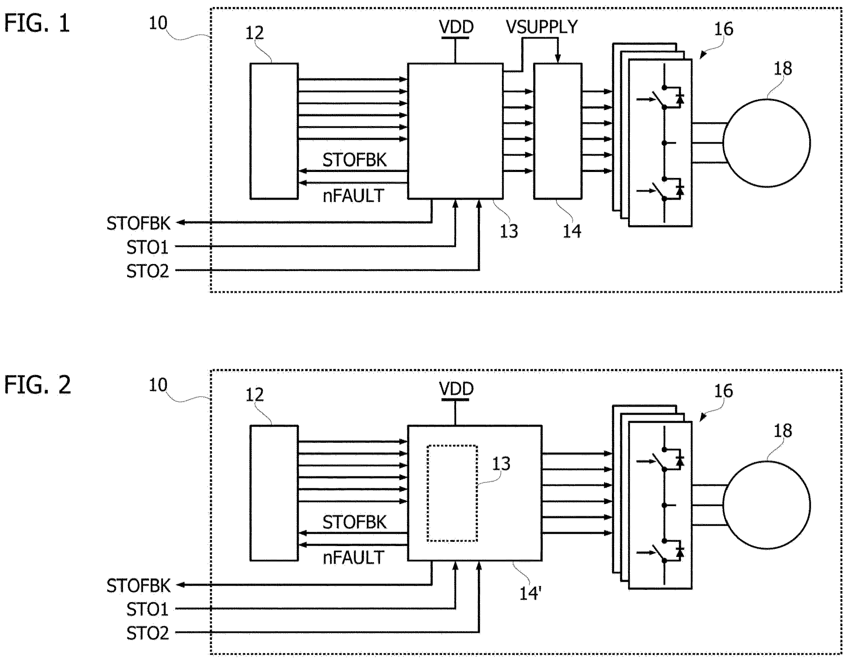

In particular, some embodiments relate to a safety circuit for use in an architecture as exemplified in the circuit block diagram of Figure 1, where the safety circuit is implemented as a stand-alone integrated circuit. Figure 1 shows an industrial driver 10 that includes a control unit 12 (e.g., a microcontroller unit, MCU), a safety circuit 13 that implements a safety STO function, a two-channel gate driver device 14, a power stage 16 (e.g., a three-phase inverter), and a motor 18 (e.g., a permanent magnet synchronous motor, PMSM, or a brushless DC motor, BLDC). The microcontroller 12 produces pulse-width modulated (PWM) driving signals (e.g., logic signals in a low-voltage domain), e.g., six PWM driving signals for controlling six switches of the three-phase inverter 16. The safety circuit 13 receives the PWM driving signals from the microcontroller 12, receives a system supply voltage VDD, and receives (e.g., from outside of the industrial driver 10) a first safety signal STO1 and a second safety signal STO2 for controlling the integrated STO function of the first and second channels, respectively. In particular, signals STO1 and STO2 may be active-low, meaning that a low logic value ('0') corresponds to the respective STO function being demanded (asserted condition), and a high logic value (` 1') corresponds to the respective STO function not being demanded (de-asserted condition). The safety circuit 13 produces output PWM driving signals (e.g., six PWM signals, still in the low-voltage domain) that are passed to the gate driver device 14, and produces a supply voltage VSUPPLY for the gate driver device 14. As further discussed in the following, the first safety signal STO1 substantially influences the propagation of the PWM driving signals from the microcontroller 12 to the gate driver device 14 (e.g., by setting the output PWM driving signals to a safe value when signal STO1 is asserted), while the second safety signal STO2 substantially influences the biasing of the gate driver device 14 (e.g., by cutting the supply voltage VSUPPLY when signal STO2 is asserted). Additionally, the safety circuit 13 produces an STO feedback signal STOFBK that is propagated to the microcontroller 12 and/or outside of the industrial driver 10, and a diagnosis signal nFAULT that is propagated to the microcontroller 12. The gate driver device 14 receives the PWM driving signals and the supply voltage VSUPPLY from the safety circuit 13, shifts the PWM driving signals to the driving voltage (e.g., in a high-voltage domain) and passes the shifted PWM driving signals to the power stage 16 that consequently produces respective PWM motor driving signals. The motor 18 is thus driven by the power stage 16.

Some embodiments relate to a safety circuit for use in an architecture as exemplified in the circuit block diagram of Figure 2, where the safety circuit is integrated into another IC, in particular it is integrated in the gate driver device. Here, differently from the architecture of Figure 1, a gate driver device 14' receives the PWM driving signals from microcontroller 12, receives the system supply voltage VDD, and receives (e.g., from outside of the industrial driver 10) the first and second safety signals STO1 and STO2. The gate driver device 14' incorporates the hardware of the safety circuit 13 and implements the same STO safety functions, thus it directly produces the shifted PWM driving signals that are passed to the power stage 16, as well as the STO feedback signal STOFBK and the diagnosis signal nFAULT.

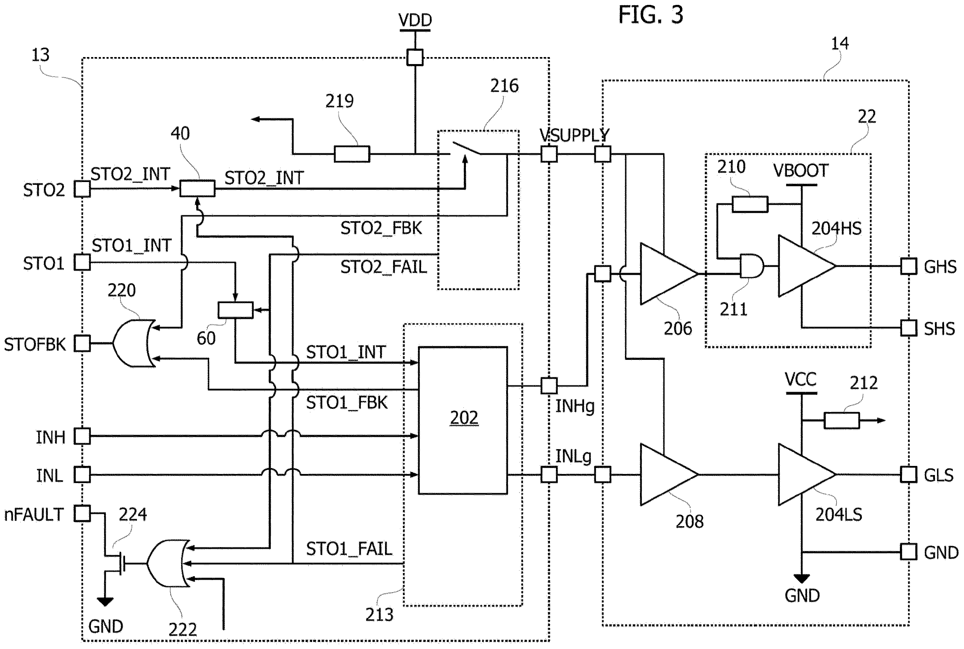

Figure 3 is a circuit block diagram exemplary of a possible architecture of a safety circuit 13 configured to be coupled to a gate driver device 14 as discussed with reference to Figure 1. The safety circuit 13 may be based on a two-channel architecture, it may include full self-diagnostics without external intervention (i.e., the STO function itself may verify internally the presence of failures), and it may include power supply monitoring for overvoltage (OV) and/or undervoltage (UV) events. In particular, with regard to the integrated STO function, the safety circuit 13 is provided with two channels. Signal STO1 acts on the control logic 202 of the safety circuit 13, in particular by forcing the gate driving signals INHg, INLg provided by the logic 202 to the driver circuits 204HS, 204LS of the gate driver device 14 (via a level shifter 206 and a pre-driver 208 of the gate driver device 14, respectively) to a value that results in the external power stage 16 being turned off. Signal STO2 acts on the power supply section of the gate driver device 14, in particular by de-activating (e.g., turning off, cutting) the power supply of the power section that is arranged downstream of the control logic 202 (e.g., the power supply of the level shifter 206, of the pre-driver 208, and/or of the low-side driver circuit 204LS), so that the driver circuits 204HS, 204LS can be brought back to their default state, which implies the turn-off of the power stage 16.

It is noted that, in the circuit diagram of Figure 3, the driver circuits for a single half-bridge are visible (e.g., a single phase of the three-phase inverter 16), and similarly a single high-side PWM driving signal INH and a single low-side PWM driving signal INL are visible, for the sake of ease of illustration. In various applications, the driver circuits (e.g., 204HS, 204LS, 206, 208) and related control logic (e.g., 202) may be implemented in the safety circuit 13 and in the gate driver device 14 as many times as the number of half-bridges that are driven thereby (e.g., three times in the case of a three-phase inverter as considered herein).

Therefore, the safety circuit 13 may include the following input pads: a pad for receiving signal STO1 (active-low), a pad for receiving signal STO2 (active-low), pads for receiving the PWM driving signals INH and INL (e.g., six pads), and a pad for receiving the system supply voltage VDD. The safety circuit 13 may include as well the following output pads: a pad for providing the feedback signal STOFBK (active-high), a pad for providing the diagnosis signal nFAULT (active-low), a pad for providing the supply voltage VSUPPLY, and pads for providing the high-side gate driving signal INHg and the low-side gate driving signal INLg (e.g., six pads). The PWM driving signals INH, INL are combined with signal STO1 in the logic circuit 202 as discussed more in the detail in the following, in order to produce the high-side gate driving signal INHg that is passed to the level shifter 206 of the gate driver device 14 and the low-side driving signal INLg that is passed to the pre-driver 208 of the gate driver device 14. Again, it is noted that for the sake of ease of illustration, Figure 3 shows only a high-side PWM driving signal INH and a low-side PWM driving signal INL as well as a high-side gate driving signal INHg and a low-side gate driving signal INLg. Also, in certain embodiments the PWM driving signals INH and INL may be replaced by a first input providing a single PWM driving signal that indicates to the gate driving circuitry when the high-side or the low-side driver must be driven high, and a second input providing an enable signal ENABLE indicating if both the high-side and the low-side driver have to be driven low, in a manner known per se.

The level shifter 206, which is biased (supplied) by the supply voltage VSUPPLY selectively connectable via the safety circuit 13 to the system supply voltage VDD (using signal STO2 as discussed in more detail in the following), passes the high-side gate driving signal INHg to the high-side driver circuit 204HS. The high-side driver circuit 204HS is implemented in a floating section 22 of the gate driver device 14 and is biased (supplied) by a bootstrap voltage VBOOT, and produces the high-side output signal between a high-side gate output pad GHS and a high-side source output pad SHS (e.g., with pad GHS being configured for coupling to a gate terminal of a high-side power switch of a half-bridge, and pad SHS being configured for coupling to a source terminal of the same high-side power switch). The floating section 22 may also include an undervoltage protection circuit 210 coupled to the bootstrap supply node VBOOT and configured to produce an undervoltage detection signal that forces to a low value the driving signal of the high-side driver 204HS when an undervoltage condition is detected at node VBOOT. For instance, circuit 210 may assert (low) its output signal in response to an undervoltage being detected, and the output signal from the level shifter 206 may be combined with the output signal from circuit 210 by an AND logic gate 211 before being passed to the high-side driver circuit 204HS.

The pre-driver 208, which is selectively biased (supplied) by the supply voltage VSUPPLY selectively connectable via the safety circuit 13 to the system supply voltage VDD (using signal STO2 as discussed in more detail in the following), passes the low-side gate driving signal INLg to the low-side driver circuit 204LS. The low-side driver circuit 204HS is biased (supplied) by a low-side supply voltage VCC, and produces the low-side output signal between a low-side gate output pad GLS and a ground pad GND (e.g., with pad GLS being configured for coupling to a gate terminal of a low-side power switch of the half-bridge, and pad GND being configured for coupling to a source terminal of the same low-side power switch). An undervoltage protection circuit 212 coupled to the low-side supply voltage node VCC is configured to produce an undervoltage detection signal that is passed to a protection logic circuit (not visible in Figure 3) and forces to a low value the driving signals of all the high-side drivers 204HS and all the low-side drivers 204LS when an undervoltage condition is detected at node VCC.

In certain embodiments (not visible in the Figures annexed herein), in addition or as an alternative to the "selective" biasing of circuits 206 and 208, the supply voltage of the low-side driver circuit 204LS may be selectively connectable via the safety circuit 13 to the system supply voltage VDD (using signal STO2 as discussed in more detail in the following). In other words, the second channel (STO2) of the STO safety function can be applied to any of the supply voltages of circuits 206, 208, and/or 204LS.

The signal STO1 received from outside is passed as an internal signal STO1_INT to a first STO intervention circuit 213 of the safety circuit 13 (e.g., to the logic circuit 202) to control the propagation of signals INH, INL as signals INHg, INLg. Optionally, the intervention circuit 213 and in particular the logic circuit 202 produces a feedback signal STO1_FBK that is asserted (high) to indicate that the STO1 function has been correctly activated, as discussed in more detail in the following. Optionally, a self-diagnosis circuit is provided in the STO intervention circuit 213 and is configured to detect faults in the first STO channel (STO1). If a fault in the first STO channel (STO1) is detected, a respective fault signal STO1_FAIL is asserted (high). Optionally, the fault signal STO1_FAIL also controls a backup activation circuit 40 that is configured to force the activation signal of the second STO channel (i.e., signal STO2_INT) to an asserted (low) state, as discussed in more detail in the following.

The signal STO2 received from outside is passed as an internal signal STO2_INT to a second STO intervention circuit 216 of the safety circuit 13 to control the propagation of the system supply voltage VDD to the level shifter 206 and/or to the pre-driver 208 and/or to the low-side driver circuit 204LS. Optionally, the intervention circuit 216 produces a feedback signal STO2_FBK that is asserted (high) to indicate that the STO2 function has been correctly activated, as discussed in more detail in the following. Optionally, a self-diagnosis circuit is provided in the STO intervention circuit 216 and is configured to detect faults in the second STO channel (STO2). If a fault in the second STO channel (STO2) is detected, a respective fault signal STO2_FAIL is asserted (high). Optionally, the fault signal STO2 FAIL also controls a backup activation circuit 60 that is configured to force the activation signal of the first STO channel (i.e., signal STO1_INT) to an asserted (low) state, as discussed in more detail in the following.

Additionally, an undervoltage/overvoltage protection circuit 219 coupled to the system supply voltage node VDD is configured to produce an undervoltage/overvoltage detection signal that is passed to the protection logic circuit (not visible in Figure 2) and forces to a low value the driving signals of all the high-side drivers 204HS and all the low-side drivers 204LS when an undervoltage/overvoltage condition is detected at node VDD.

The feedback signals STO1_FBK and STO2_FBK may be combined by a logic gate 220 (e.g., an OR logic gate) to produce the overall feedback signal STOFBK that is asserted (high) when any one of the STO1 and STO2 channels is correctly activated (e.g., when any one of signals STO1_FBK and STO2_FBK is asserted). The fault signals STO1_FAIL and STO2_FAIL produced by circuits 213 and 216 may be combined with a third fault signal by a logic gate 222 (e.g., an OR logic gate) to produce a gate control signal for a pull-down (open-drain) transistor 224 coupled between pad nFAULT and ground GND. The third fault signal may be asserted (high) when other fault conditions are detected (e.g., undervoltage, overvoltage, thermal shutdown, etc.). Therefore, in response to any of the three fault signals being asserted (high), the pull-down transistor 224 is activated and the overall fault signal nFAULT is asserted (low).

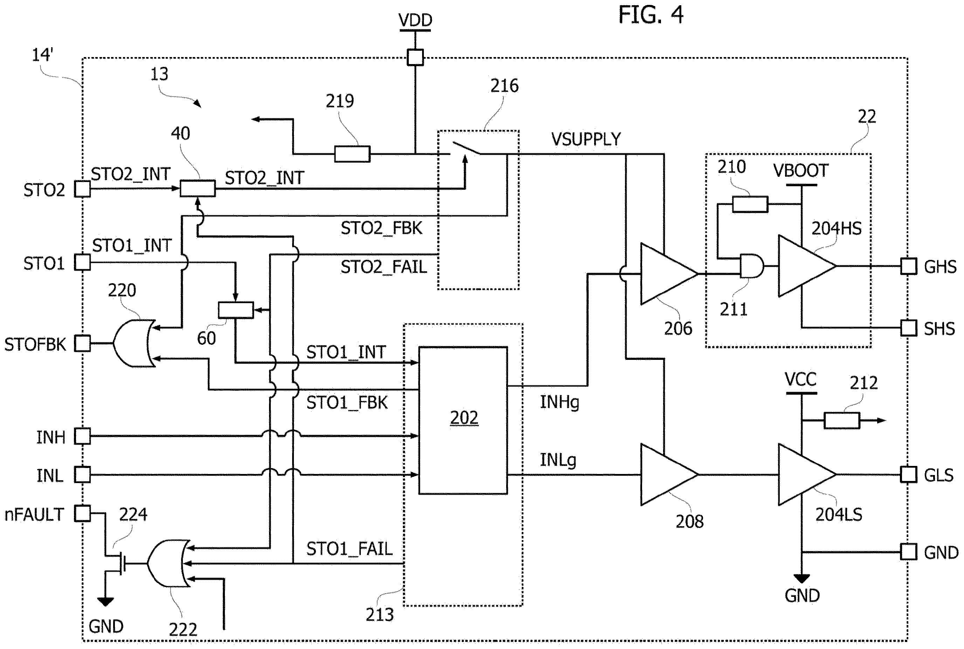

Figure 4 is a circuit block diagram exemplary of a possible architecture of a safety circuit 13 configured to be integrated in a gate driver device 14' as discussed with reference to Figure 2. It will be noted that the architecture of the safety circuit illustrated in Figure 4 is substantially the same as the architecture illustrated in Figure 3, and operates according to the same principles, with the difference that the gate driving signals INHg, INLg and the supply voltage VSUPPLY are passed internally within a same integrated circuit. Therefore, the following detailed description applies equally to all embodiments.

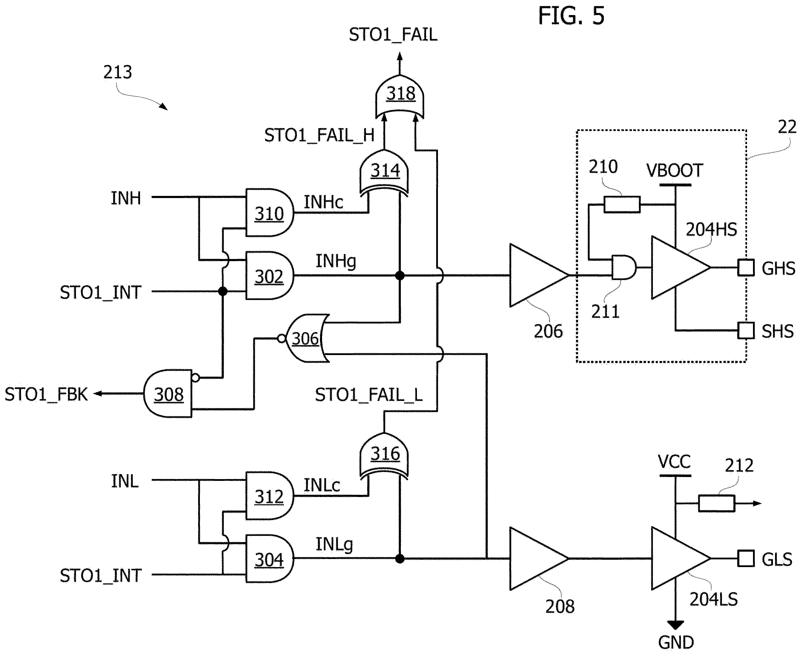

Figure 5 is a circuit block diagram exemplary of a possible implementation of the first STO intervention circuit 213. As anticipated, signal STO1_INT is asserted (low) to force to a low logic value the gate driving signal INHg for the high-side driver 204HS (passed via the level shifter 206) and the gate driving signal INLg for the low-side driver 204LS (passed via the pre-driver 208). In other words, signal STO1_INT acts as an enable signal: when signal STO1_INT is high, operation of the drivers 204HS and 204LS takes place as directed by the PWM signal(s) issued by the microcontroller 12, and when signal STO1_INT is low, drivers 204HS and 204LS are forced to an off state. For instance, the STO intervention circuitry 213 includes a first AND logic gate 302 that combines signals INH and STO1_INT to produce the high-side gate driving signal INHg that is passed to the level shifter 206, and a second AND logic gate 304 that combines signals INL and STO1_INT to produce the low-side gate driving signal INLg that is passed to the pre-driver 208.

Additionally, the first STO intervention circuit 213 may include feedback logic circuitry configured to assert (high) the feedback signal STO1_FBK to indicate that the STO1 function has been correctly activated, in particular by asserting (high) signal STO1_FBK when the safety signal STO1 is asserted (low) and both the gate driving signals INHg, INLg are low. The STO intervention circuitry 213 may thus include a NOR logic gate 306 that combines signals INHg and INLg, and a third AND logic gate 308 that combines the output from gate 306 with the complement of signal STO1_INT to produce the feedback signal STO1_FBK. Alternatively, signal STO1_FBK may be produced at the output of a three-input NOR logic gate that combines signals INHg, INLg and STO1_INT.

Additionally, the first STO intervention circuit 213 may be provided with self-diagnosis circuitry to produce the fault signal STO1_FAIL of the first STO channel. The STO intervention circuitry 213 may thus include a fourth AND logic gate 310 that replicates the operation of gate 302 (i.e., a redundant control path that combines signals INH and STO1_INT) to produce a high-side check signal INHc, and a fifth AND logic gate 312 that replicates the operation of gate 304 (i.e., a redundant control path that combines signals INL and STO1_INT) to produce a low-side check signal INLc. The STO intervention circuitry 213 may include a first XOR logic gate 314 that combines signals INHg and INHc to produce a first fail signal STO1_FAIL_H that is asserted (high) if signals INHg and INHc have two different logic values, indicating a failure. The STO intervention circuitry 213 may include a second XOR logic gate 316 that combines signals INLg and INLc to produce a second fail signal STO1_FAIL_L that is asserted (high) if signals INLg and INLc have two different logic values, indicating a failure. The STO intervention circuitry 213 may include an OR logic gate 318 that combines signals STO1_FAIL_H and STO1_FAIL_L to produce the first fault signal STO1 FAIL, which is asserted (high) when any of the signals STO1_FAIL_H and STO1_FAIL_L is asserted.

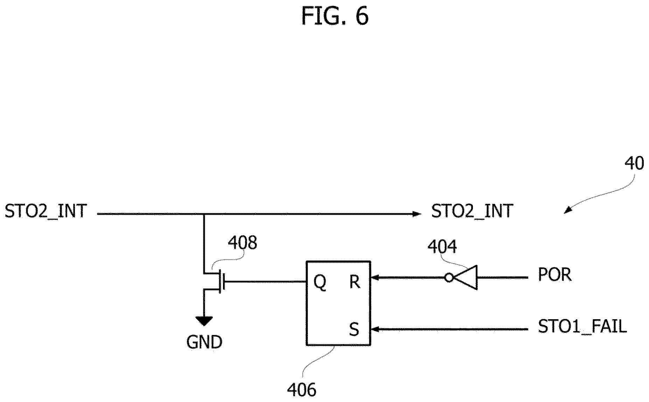

When a fail condition is detected by any of signals STO1_FAIL H and STO1_FAIL_L being asserted (high) - that is, if the STO1 path is not reliable anymore - the fault signal STO 1 FAIL is asserted (high) and the signal STO2_INT may be consequently asserted (e.g., forced to a low logic value) to activate independently the second channel of the STO function (to disconnect the supply voltage VDD), until a further POR signal (Power On Reset) is provided. Therefore, as anticipated with reference to Figures 3 and 4, the safety circuit 13 may further include a backup activation circuit 40 as exemplified in the circuit diagram of Figure 6, which is configured to force signal STO2_INT to an asserted (low) state. In particular, the backup activation circuit 40 may include an inverter gate 404 that produces the complement of the Power On Reset signal POR, and a latch element 406 (e.g., a set-reset flip-flop) that receives the fault signal STO1_FAIL at its set input terminal S and the output from inverter 404 at its reset input terminal R and produces an output signal at its data output terminal Q. The backup activation circuit 40 may further include a pull-down switch 408 connected between the propagation line of signal STO2_INT and ground GND, the switch 408 being controlled to be conductive when the output signal from latch 406 is asserted (high) and non-conductive when the output signal from latch 406 is de-asserted (low). For instance, switch 408 may include an open-drain MOS transistor having its gate terminal coupled to the data output terminal Q of latch 406. Therefore, if the fault signal STO1_FAIL is asserted (high), the latch element 406 is set (Q = 1) until a next power-up (POR = 0), and the internal safety signal STO2_INT is asserted (low).

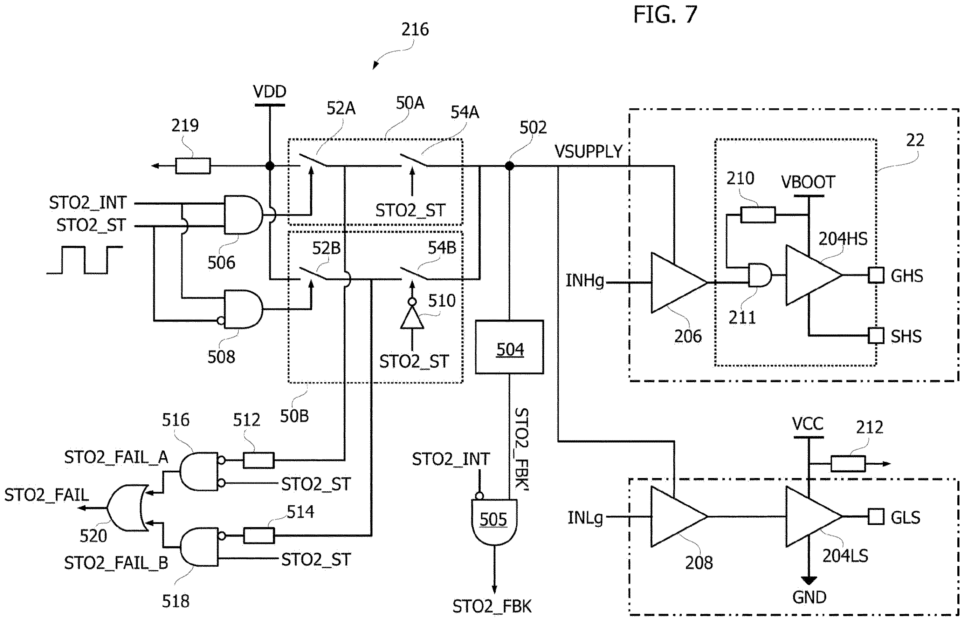

Figure 7 is a circuit block diagram exemplary of a possible implementation of the second STO intervention circuit 216. As anticipated, signal STO2_INT is asserted (low) to disconnect the system supply node VDD from the driver portion of the gate driver device 14 (particularly, from circuits 206 and/or 208 and/or 204LS). For instance, the STO intervention circuitry 216 includes a first channel 50A and a second channel 50B for propagating voltage VDD to circuits 206, 208 and/or 204LS, with the second channel arranged in parallel to the first one. The two channels can be used independently to supply the circuits 206, 208, and/or 204LS. The first channel 50A includes a first switch 52A and optionally a second switch 54A connected in series between the system supply node VDD and a downstream power supply node 502 by which circuits 206, 208 and/or 204LS are biased. The second channel 50B includes a first switch 52B and optionally a second switch 54B connected in series between node VDD and node 502. The switches 52A and 52B are controlled by signal STO2_INT (possibly gated by a logic gate for self-diagnosis purposes, as described more in detail in the following) so that, when signal STO2_INT is asserted (low), both switches 52A and 52B are open (independently from the value of the self-test signal STO2_ST, as discussed in the following) and the power supply at node 502 is cut, thereby activating the STO2 functionality.

Additionally, the second STO intervention circuit 216 may include feedback logic circuitry configured to assert (high) the feedback signal STO2 _FBK to indicate that the STO2 function has been correctly activated, in particular by asserting (high) signal STO2 _FBK when the voltage at node 502 is low. The STO intervention circuitry 216 may thus include an undervoltage detector (e.g., comparator) 504 coupled to node 502 that asserts (high) the feedback signal STO2 _FBK when the voltage VSUPPLY at node 502 is lower than a threshold. Optionally, the STO intervention circuitry 216 may additionally include an AND logic gate 505 that combines the output from undervoltage detector 504 with the complement of signal STO2_INT to produce the feedback signal STO2_FBK, so that the feedback signal STO2_FBK is asserted in response to the voltage at node 502 being lower than a threshold value while the second safety signal STO2_INT is asserted.

Additionally, the second STO intervention circuit 216 may be provided with self-diagnosis circuitry to produce the fault signal STO2 FAIL of the second STO channel. The STO intervention circuitry 216 may thus be configured to receive a self-test signal STO2_ST (e.g., a square wave signal or clock signal produced by an oscillator), and may include a first AND logic gate 506 that combines signals STO2_INT and STO2_ST, a second AND logic gate 508 that combines signals STO2_INT and the complement of signal STO2_ST, and an inverter gate 510 that produces the complement of signal STO2_ST. Switch 52A is controlled by the signal output by gate 506, switch 52B is controlled by the signal output by gate 508, switch 54A is controlled by the self-test signal STO2_ST, and switch 54B is controlled by the complement of the self-test signal STO2_ST produced by inverter 510. For all four switches, a low control signal means switch open, and a high control signal means switch closed. Additionally, the self-diagnosis circuitry may include an undervoltage detector (e.g., comparator) 512 coupled to the node intermediate switches 52A and 54A, which asserts (high) a respective signal when the voltage at that node is lower than a threshold, and an undervoltage detector (e.g., comparator) 514 coupled to the node intermediate switches 52B and 54B, which asserts (high) a respective signal when the voltage at that node is lower than a threshold. Additionally, the self-diagnosis circuitry may include an AND logic gate 516 that combines the complement of the signal output by detector 512 and the complement of the self-test signal STO2_ST to produce a first fail signal STO2_FAIL_A that is asserted (high) if both signals STO2_ST and the output from detector 512 have a low logic value, indicating a failure, and de-asserted (low) otherwise, indicating that the check is passed. It is noted that the same logic signal STO2_FAIL_A may be produced as the output of a NOR logic gate that combines signal STO2_ST and the signal output by detector 512. Additionally, the self-diagnosis circuitry may include an AND logic gate 518 that combines the complement of the signal output by detector 514 and the self-test signal STO2_ST to produce a second fail signal STO2_FAIL_B that is asserted (high) if signal STO2_ST has a high logic value and the output from detector 514 has a low logic value, indicating a failure, and de-asserted otherwise, indicating that the check is passed. The STO intervention circuitry 216 may include an OR logic gate 520 that combines signals STO2_FAIL_A and STO2_FAIL_B to produce the second fault signal STO2_FAIL, which is asserted (high) when any of the signals STO2 FAIL A and STO2 FAIL B is asserted.

Therefore, if no faults are present:
- when STO2_INT is asserted (low), independently from the value of the self-test signal STO2_ST, switches 52A and 52B are open, the voltage downstream of switches 52A and 52B is low, the comparators 512 and 514 output high signals which drive to a de-asserted (low) state the fault signal STO2_FAIL, and the comparator 504 drives to an asserted (high) state the feedback signal STO2_FBK;
- when STO2_INT is de-asserted (high), if the self-test signal STO2_ST is low ('0') the first channel 50A is tested and the second channel 50B is used to supply the driver circuits: switches 52A and 54A are expected to be open, switches 52B and 54B are expected to be closed, the fail signal STO2_FAIL_A is driven to a de-asserted (low) state by the high output of comparator 512, the fail signal STO2_FAIL _B is driven to a de-asserted (low) state by the low value of the self-test signal STO2_ST, the fault signal STO2_FAIL is driven to a de-asserted (low) state by the OR logic gate 520, and the comparator 504 drives to a de-asserted (low) state the feedback signal STO2_FBK;
- when STO2_INT is de-asserted (high), if the self-test signal STO2_ST is high (` 1') the second channel 50B is tested and the first channel 50A is used to supply the driver circuits: switches 52B and 54B are expected to be open, switches 52A and 54A are expected to be closed, the fail signal STO2_FAIL _B is driven to a de-asserted (low) state by the high output of comparator 514, the fail signal STO2_FAIL_A is driven to a de-asserted (low) state by the high value of the self-test signal STO2_ST, the fault signal STO2_FAIL is driven to a de-asserted (low) state by the OR logic gate 520, and the comparator 504 drives to a de-asserted (low) state the feedback signal STO2_FBK.

In the case of a fault (e.g., any of switches 52A, 54A, 52B, 54B being closed when expected to be open), the fault is detected by one of detectors 512 and 514, the corresponding fail signal STO2_FAIL_A or STO2_FAIL _B is asserted (high), and the combined fault signal STO2 FAIL is asserted (high).

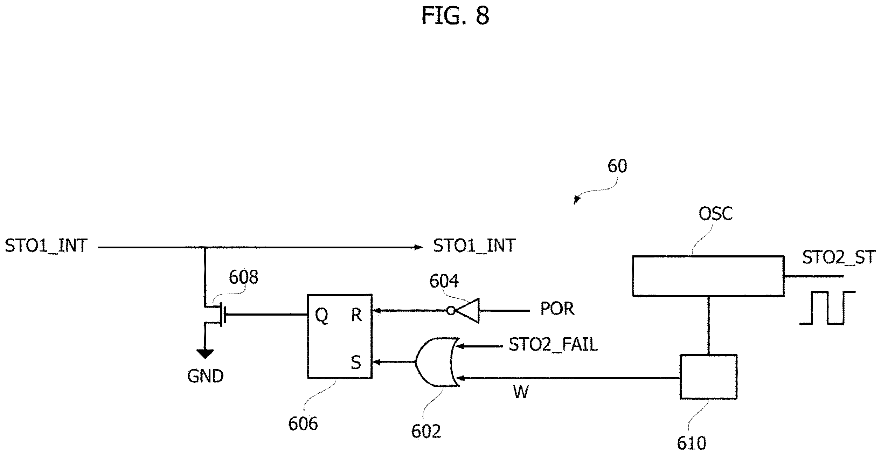

When a fail condition is detected by any of signals STO2_FAIL_A and STO2_FAIL_B being asserted (high) - that is, if the STO2 path is not reliable anymore - the fault signal STO2_FAIL is asserted (high) and the signal STO1_INT may be consequently asserted (e.g., forced to a low logic value) to activate independently the first channel of the STO function (to "gate" the driving signals INHg, INLg), until a further POR signal (Power On Reset) is provided. Therefore, as anticipated with reference to Figures 3 and 4, the safety circuit 13 may further include a backup activation circuit 60 as exemplified in the circuit block diagram of Figure 8, which is configured to force signal STO1_INT to an asserted (low) state. In particular, the backup activation circuit 60 may include an inverter gate 604 that produces the complement of the Power On Reset signal POR, and a latch element 606 (e.g., a set-reset flip-flop) that receives the fault signal STO2_FAIL at its set input terminal S and the output from inverter 604 at its reset input terminal R and produces an output signal at its data output terminal Q. The backup activation circuit 60 may further include a pull-down switch 608 connected between the propagation line of signal STO1_INT and ground GND, the switch 608 being controlled to be conductive when the output signal from latch 606 is asserted (high) and non-conductive when the output signal from latch 606 is de-asserted (low). For instance, switch 608 may include an open-drain MOS transistor having its gate terminal coupled to the data output terminal Q of latch 606. Therefore, if the fault signal STO2_FAIL is asserted (high), the latch element 606 is set (Q = 1) until a next power-up (POR = 0), and the internal safety signal STO1_INT is asserted (low). Optionally, the backup activation circuit 60 may include a window watchdog circuit 610 coupled to the oscillator OSC that produces the self-test signal STO2_ST. Circuit 610 monitors the frequency of oscillator OSC and, if the frequency is outside of an expected range (e.g., too low or too high), it asserts (high) a respective watchdog signal W. The backup activation circuit 60 may include an OR logic gate 602 that combines signals STO2_FAIL and W to force assertion of the internal safety signal STO1_INT in case of a self-test fail of the oscillator (i.e., in this case it is the output from the OR logic gate 602 that is passed to the set input terminal S of the latch element 606).

One or more embodiments as exemplified herein may thus provide a safety circuit, possibly integrated in a gate driver device, that integrates a certified STO safety function, bringing about one or more of the following advantages:
- reduced number of components in the final application, resulting in improved compactness and reduced cost (reduced Bill Of Materials, BOM);
- reduced time and cost for the safety certification of the final application; and
- high IP reusability with low risk.

Without prejudice to the underlying principles, the details and embodiments may vary, even significantly, with respect to what has been described by way of example only, without departing from the extent of protection.

The extent of protection is determined by the annexed claims.

## Claims

1. A safety circuit (13), comprising:
at least one PWM input pin configured to receive at least one PWM driving signal (INH, INL);
a power supply input pin configured to receive a system supply voltage (VDD);
a first safety input pin configured to receive a first safety signal (STO1, STO1_INT) and a second safety input pin configured to receive a second safety signal (STO2, STO2_INT);
a high-side driving output node configured to produce a high-side gate driving signal (INHg) and a low-side driving output node configured to produce a low-side gate driving signal (INLg);
a power supply output node (502) configured to produce a driver supply voltage (VSUPPLY);
a first logic circuit (202, 213) configured to:
- in response to said first safety signal (STO1_INT) being de-asserted, propagate said at least one PWM driving signal (INH, INL) to produce said high-side gate driving signal (INHg) and said low-side gate driving signal (INLg) as a function thereof, and
- in response to said first safety signal (STO1_INT) being asserted, disable propagation of said at least one PWM driving signal (INH, INL) and de-assert said high-side gate driving signal (INHg) and said low-side gate driving signal (INHg);
a second logic circuit (216) configured to:
- in response to said second safety signal (STO2_INT) being de-asserted, couple said power supply output node (502) to said power supply input pin to propagate said system supply voltage (VDD) as said driver supply voltage (VSUPPLY), and
- in response to said second safety signal (STO2_INT) being asserted, decouple said power supply output node (502) from said power supply input pin to disable propagation of said system supply voltage (VDD).

2. The safety circuit (13) of claim 1, wherein said at least one PWM input pin comprise a high-side PWM input pin configured to receive a high-side PWM driving signal (INH) and a low-side PWM input pin configured to receive a low-side PWM driving signal (INL), and wherein said first logic circuit (202, 213) is configured to:
- in response to said first safety signal (STO1_INT) being de-asserted, propagate said high-side PWM driving signal (INH) to said high-side driving output node to produce said high-side gate driving signal (INHg) and propagate said low-side PWM driving signal (INL) to said low-side driving output node to produce said low-side gate driving signal (INLg), and
- in response to said first safety signal (STO1_INT) being asserted, disable propagation of said high-side PWM driving signal (INH) to said high-side driving output node, disable propagation of said low-side PWM driving signal (INH) to said low-side driving output node, and de-assert said high-side gate driving signal (INHg) and said low-side gate driving signal (INHg).

3. The safety circuit (13) of claim 1 or claim 2, wherein:
said first logic circuit (202, 213) is configured to assert a first combined failure signal (STO1_FAIL) in response to a fault being detected in the operation of the first logic circuit (202, 213); and
said second logic circuit (216) is configured to assert a second combined failure signal (STO2 FAIL) in response to a fault being detected in the operation of the second logic circuit (216)
wherein the safety circuit (13) further comprises:
a first backup activation circuit (40) configured to force said second safety signal (STO2_INT) to an asserted state in response to said first combined failure signal (STO1_FAIL) being asserted; and
a second backup activation circuit (60) configured to force said first safety signal (STO1_INT) to an asserted state in response to said second combined failure signal (STO2_FAIL) being asserted.

4. The safety circuit (13) of any of the previous claims, wherein said first logic circuit (213) comprises:
a first AND logic gate (302) configured to apply AND logic processing to said at least one PWM driving signal (INH) and said first safety signal (STO1_INT) to produce said high-side gate driving signal (INHg); and
a second AND logic gate (304) configured to apply AND logic processing to said at least one PWM driving signal (INL) and said first safety signal (STO1_INT) to produce said low-side gate driving signal (INLg).

5. The safety circuit (13) of claim 4, wherein said first logic circuit (213) comprises:
a third AND logic gate (310) configured to apply AND logic processing to said at least one PWM driving signal (INH) and said first safety signal (STO1_INT) to produce a high-side check signal (INHc);
a fourth AND logic gate (312) configured to apply AND logic processing to said at least one PWM driving signal (INL) and said first safety signal (STO1_INT) to produce a low-side check signal (INLc);
a first XOR logic gate (314) configured to apply XOR logic processing to said high-side gate driving signal (INHg) and said high-side check signal (INHc) to produce a high-side failure signal (STO1_FAIL_H);
a second XOR logic gate (316) configured to apply XOR logic processing to said low-side gate driving signal (INLg) and said low-side check signal (INLc) to produce a low-side failure signal (STO1_FAIL_L); and
an OR logic gate (318) configured to apply OR logic processing to said high-side failure signal (STO1_FAIL H) and low-side failure signal (STO1_FAILL) to produce a first combined failure signal (STO1_FAIL);
wherein the safety circuit (13) further comprises a first backup activation circuit (40) configured to force said second safety signal (STO2_INT) to an asserted state in response to said first combined failure signal (STO1_FAIL) being asserted.

6. The safety circuit (13) of claim 5, wherein said first backup activation circuit (40) comprises:
a latch element (406) configured to receive said first combined failure signal (STO1_FAIL) at a respective set terminal, receive the complement (404) of a power-on-reset signal (POR) at a respective reset terminal, and produce a first activation signal at a respective data output terminal; and
a pull-down switch (408) coupled to said latch element (406) and configured to pull-down said second safety signal (STO2_INT) in response to said first activation signal being asserted.

7. The safety circuit (13) of any of the previous claims, wherein said second logic circuit (216) is configured to receive a square wave self-test signal (STO2_ST), and wherein said second logic circuit (216) comprises:
a first switch (52A) and a second switch (54A) arranged in series between said power supply input pin (VDD) and said power supply output node (502), the first switch (52A) being controlled by the output of an AND logic gate (506) configured to apply AND logic processing to said second safety signal (STO2, STO2_INT) and said self-test signal (STO2_ST), and the second switch (54A) being controlled by said self-test signal (STO2_ST); and
a third switch (52B) and a fourth switch (54B) arranged in series between said power supply input pin (VDD) and said power supply output node (502), the third switch (52B) being controlled by the output of an AND logic gate (508) configured to apply AND logic processing to said second safety signal (STO2, STO2_INT) and to the complement of said self-test signal (STO2_ST), and the fourth switch (54B) being controlled by the complement of said self-test signal (STO2_ST).

8. The safety circuit (13) of claim 7, wherein said second logic circuit (216) comprises:
a first undervoltage detector (512) configured to assert a respective output signal in response to a voltage at a node intermediate said first switch (52A) and said second switch (54A) being lower than a threshold;
a second undervoltage detector (514) configured to assert a respective output signal in response to a voltage at a node intermediate said third switch (52B) and said fourth switch (54B) being lower than a threshold;
a first logic gate (516) configured to assert a first supply failure signal (STO2_FAIL_A) in response to said self-test signal (STO2_ST) and the output signal from said first undervoltage detector (512) being de-asserted;
a second logic gate (518) configured to assert a second supply failure signal (STO2_FAIL_B) in response to said self-test signal (STO2_ST) being asserted and the output signal from said second undervoltage detector (514) being de-asserted; and
an OR logic gate (520) configured to apply OR logic processing to said first supply failure signal (STO2_FAIL_A) and second supply failure signal (STO2_FAIL_B) to produce a second combined failure signal (STO2_FAIL);
wherein the safety circuit (13) further comprises a second backup activation circuit (60) configured to force said first safety signal (STO1_INT) to an asserted state in response to said second combined failure signal (STO2_FAIL) being asserted.

9. The safety circuit (13) of claims 3 and 8, further configured (222, 224) to assert, at a diagnosis output pin, a fault signal (nFAULT) in response to any one of said first combined failure signal (STO1_FAIL) and said second combined failure signal (STO2 FAIL) being asserted.

10. The safety circuit (13) of claim 8 or claim 9, wherein said second backup activation circuit (60) comprises a watchdog circuit (610) configured to assert a watchdog signal (W) in response to the frequency of said self-test signal (STO2_ST) being outside of an expected range, and wherein said second backup activation circuit (60) is configured to force said first safety signal (STO1_INT) to an asserted state in response to said watchdog signal (W) being asserted.

11. The safety circuit (13) of claim 10, wherein said second backup activation circuit (60) comprises:
an OR logic gate (602) configured to apply OR logic processing to said second combined failure signal (STO2_FAIL) and to said watchdog signal (W);
a latch element (606) configured to receive the output signal from said OR logic gate (602) at a respective set terminal, receive the complement (604) of a power-on-reset signal (POR) at a respective reset terminal, and produce a second activation signal at a respective data output terminal; and
a pull-down switch (608) coupled to said latch element (606) and configured to pull-down said first safety signal (STO1_INT) in response to said second activation signal being asserted.

12. The safety circuit (13) of any of the previous claims, wherein:
said first logic circuit (202, 213) is configured (306, 308) to assert a first internal feedback signal (STO1_FBK) in response to said high-side gate driving signal (INHg) and said low-side gate driving signal (INHg) being de-asserted while said first safety signal (STO1_INT) is asserted;
said second logic circuit (216) is configured (504) to assert a second internal feedback signal (STO2_FBK) in response to a voltage at said power supply output node (502) being lower than a threshold value; and
the safety circuit (13) is further configured (220) to assert, at a feedback output pin, a feedback signal (STOFBK) in response to any one of said first internal feedback signal (STO1_FBK) and said second internal feedback signal (STO2_FBK) being asserted.

13. A gate driver device (14'), comprising:
a safety circuit (13) according to any of the previous claims;
a level shifter circuit (206) and an output high-side driver circuit (204HS), the level shifter circuit (206) being configured to receive said high-side gate driving signal (INHg) and drive the output high-side driver circuit (204HS) as a function thereof;
a pre-driver circuit (208) and an output low-side driver circuit (204LS), the pre-driver circuit (208) being configured to receive said low-side gate driving signal (INLg) and drive the output low-side driver circuit (204LS) as a function thereof;
wherein said level shifter circuit (206) and/or said pre-driver circuit (208) and/or said output low-side driver circuit (204LS) are coupled to said power supply output node (502) to be biased by said driver supply voltage (VSUPPLY).

14. The gate driver device (14') of claim 13, wherein said output high-side driver circuit (204HS) is biased by a bootstrap voltage (VBOOT) and said output low-side driver circuit (204LS) is biased by a low-side supply voltage (VCC), and wherein the gate driver device (14') comprises:
a first undervoltage protection circuit (210, 211) configured to sense said bootstrap voltage (VBOOT) and to de-assert a driving signal of the output high-side driver circuit (204HS) in response to said bootstrap voltage (VBOOT) being lower than a threshold; and/or
a second undervoltage protection circuit (212) configured to sense said low-side supply voltage (VCC) and to de-assert a driving signal of the output high-side driver circuit (204HS) and a driving signal of the output low-side driver circuit (204LS) in response to said low-side supply voltage (VCC) being lower than a threshold; and/or
an undervoltage/overvoltage protection circuit (219) configured to sense said system supply voltage (VDD) at said power supply input pin and to de-assert a driving signal of the output high-side driver circuit (204HS) and a driving signal of the output low-side driver circuit (204LS) in response to said system supply voltage (VDD) being outside of an expected range.

15. A driver system (10), comprising:
a control unit (12);
a safety circuit (13) according to any of claims 1 to 12 coupled to a gate driver device (14), or a gate driver device (14') according to claim 13 or claim 14; and
a power stage (16);
wherein:
the control unit (12) is configured to produce said at least one PWM driving signal (INH, INL) for controlling operation of the power stage (16);
the safety circuit (13) is configured to receive said at least one PWM driving signal (INH, INL), said first safety signal (STO1) and said second safety signal (STO2) and produce said high-side gate driving signal (INHg), said low-side gate driving signal (INLg) and said driver supply voltage (VSUPPLY); and
the gate driver device (14, 14') is configured to receive said high-side gate driving signal (INHg), said low-side gate driving signal (INLg) and said driver supply voltage (VSUPPLY) and produce shifted PWM driving signals for driving respective switches of said power stage (16).
